# EUROPEAN PATENT SPECIFICATION

(11) **EP 2 166 826 B1**
(45) Date of publication and mention of the grant of the patent: **24.08.2011**
(21) Application number: 09016073.0
(22) Date of filing: 27.05.1999
(51) Int. Cl.: H05K 1/14, H05K 1/16

(54) **A package for power converters with improved transformer operations**
Gehäuse für Stromwandler mit verbessertem Transformatorbetrieb
Emballage pour convertisseurs d'alimentation avec opérations de transformateur améliorées

(30) Priority: 28.05.1998 US 86365
(43) Date of publication of application: 24.03.2010
(62) Divisional of application: 99925964.1
(73) Proprietor: DET International Holding Limited, George Town, Grand Cayman (KY)
(72) Inventor: Jitaru, Ionel, Tucson, AZ 85711 (US)
(74) Representative: Rüfenacht, Philipp Michael

(56) References cited:
- JP-A- 9 199 247
- US-A- 5 263 868
- US-A- 5 299 094
- US-A- 5 321 380
- US-A- 5 617 300
- US-A- 5 724 016

## Description

### Background of the Invention:

This invention relates generally to the electrical design and mechanical packaging of electronic components.

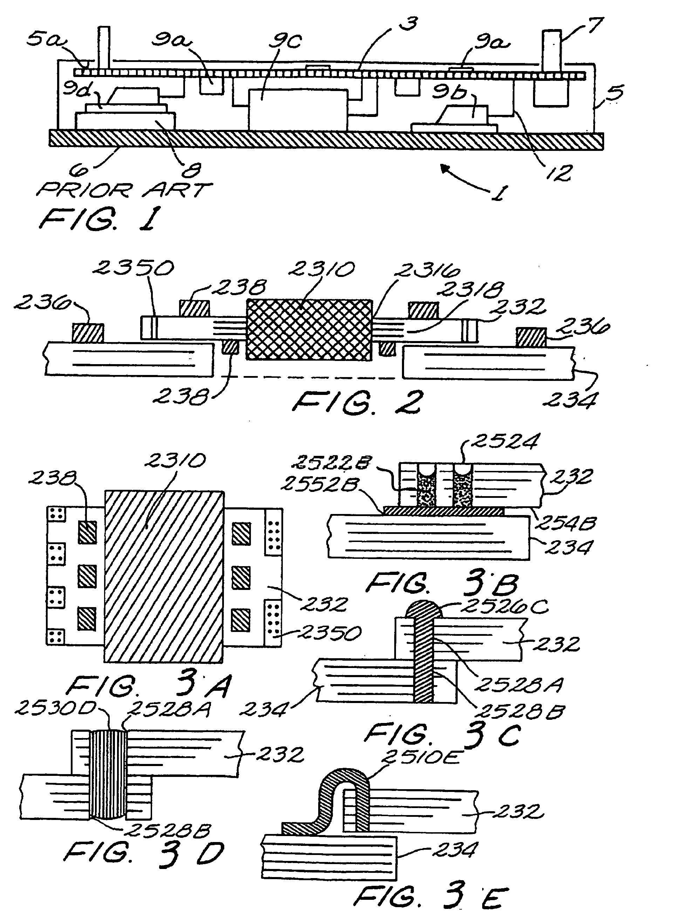

One approach to packaging electric components in power converters (Fig. 1) includes a housing which both encloses the components and means of heat extraction from the components. The house includes a non-conductive casing 5 and an aluminum heat-sinking base. A printed circuit board (PCB) 3 is mounted next to the upper wall 5a of the casing. Conductive pins 7 are attached directly to the PCB 3 and extend up through the wall 5a. Electronic components 9a, 9c are mounted to one or both sides of the PCB 3. Larger side components such as the transformer 9c are mounted to the lower side for space reason. Power dissipating devices such as 9b are mounted directly on the base-plate 6. for better heat transfer. The power components 9b are electrically connected to the PBC by leads 12. Some of the power dissipating devices, 9d, are attached to the base plate via a thermally conductive insulator material 8. Structure 1 may be filled with an encapsulant, which acts as a heat spreader and provides mechanical support. In the case when a hard epoxy encapsulant is used a"buffer coating" material is used to protect some of the components.

US 5,724,016 (Roessler et al.)discloses a power magnetic device including a multilayer circuit board with windings coupled by vias and a magnetic core. Within the vias a conductive substance such as solder interconnects the windings and the device to a planar substrate. Clamps that are coupled to the planar substrate via conductors secure the device to the planar substrate.

US 5,617,300 A (Anzawa et al.) discloses a method for connecting two printed substrates. A first substrate is a multilayer substrate where the different layers are interconnected by through holes. For interconnecting the two substrates, a second substrate includes connection patterns each having a through hole and the first substrate includes connection patterns that are facing connection patterns of the second substrate. The substrates are connected by solder provided on the connection patterns. In a further embodiment the first substrate includes vent holes permitting degassing when solder enters the through holes. The substrate arrangement may also include a magnetic element with a core that penetrates through the multilayer substrate and extends into a containing hole in a substrate. The first substrate also includes through holes that are positioned opposing to the through holes of the second substrate.

### Summary of the invention

This invention relates to the electrical design a mechanical packaging of electronic components.

According to the invention, an electronic assembly comprises:
a) an electronic board having an opening therein, said electronic board further including two pads positioned on a first surface of said electronic board proximate to said opening;
b) a multilayer circuit board having secured thereto a transformer, said multilayer circuit board positioned such that a portion of a first surface of said multilayer circuit board engages the first surface of said electronic board such that a portion of a core of said transformer extends into the opening of said electronic board, said multilayer circuit board having at least two channels there through, each of said channels aligned with one of said at least two pads of said electronic board;
c) solder extending through said at least two channels in said multilayer circuit board, said solder bonded to the channel and to an Associated pad on said electronic board; and
d) at least one electronic component secured to the first surface of said multilayer circuit board and enclosed within said opening in said electronic board.

As background, the invention provides a packaging technology for power converters and power magnetics. The packaging methodology provides a compact, inexpensive, easy to manufacture. The invention features a package for electrical components held on a circuit board. In this packaging concept most of the power magnetic elements are constructed into the multilayers PCB. The windings of the magnetic elements such as transformer, inductors, and in some cases event signal transformers are incorporated in the multilayers PCB. The top layer and some portion of the bottom layer are also support for electronic components. The windings of the magnetic elements are contained inside of the multilayers PCB; the electronic components are placed on the top and on the bottom of the PCB. Some of the components are located on top of the windings and the interconnections between the magnetic elements. In this way the footprint of the magnetic elements is reduced to the footprint of the transformer core. The power-dissipating devices replaced on pads, which have a multitude of copper coated via to the other side of the PCB. The heat transferred to the other side of the PCB can be further spread using a larger pad or transferred to a metallic base-plate attached to the PCB through an isolating material. For air-cooled due to the limited surface of the heat spreader, an additional heat sink is attached to the heat spreader to increase its cooling area.

The unique aspect of this packaging concept is the fact that the magnetic element's windings are incorporated on the multilayers PCB construction which also serves as a support for power-dissipating components and some of the control components. The heat from the power-dissipating components is extracted through copper coated via which transfer the heat to the other side of the PCB. The heat is further transferred to a metal base plate connected to the PCB via a thermally conductive insulator. For airflow cooling applications the heat spreader connected to the thermal via can serve as a cooling surface. A heatsink can be also attached to the heat spreader to increased the heat dissipation area.

The invention, together with various embodiments thereof, will be more fully explained by the accompanying drawings and the following descriptions.

### Drawings in Brief:

Figure 1 is a cross-sectional side view of prior art components packaging.
Figure 2 presents a multilayer PCB which contain the magnetic element and the high frequency switching electronic components of the electronic circuit.
Figure 3A presents the multilayer PCB structure that incorporates the magnetic element and the high frequency electronic components.
Figure 3B presents a method of attaching the power PCB to the mother PCB using copper coated via and solder penetrating through copper coated via.
Figure 3C presents a method of attaching the power PCB to the mother PCB using through hole pins.
Figure 3D presents a method of attaching the power PCB to the mother PCB using a pressed insert.
Figure 3E presents a method of attaching the power PCB to the mother PCB using surface mounted pins.
Figure 3F presents a method of attaching the power PCB to the mother PCB using two pressed inserts and a screw.
Figure 4 presents the same structure depicted in figure 11 wherein surface mounted components are placed on both side of the mother PCB.
Figure 5A presents the same structure depicted figure 11 wherein a cooling plate is attached to the mother PCB.
Figure 5B presents the same structure depicted in figure 15A wherein the cooling plate is replaced by an isolated metal substrate, wherein surface mounted components are placed in the space between power PCB and isolated metal substrate.
Figure 5C presents an embodiment wherein the magnetic element is attached to an isolated metal substrate composed by a dielectric material copper foil, and metal plate.
Figure 6 presents another embodiment of this invention wherein the magnetic core goes through both the power PCB and the mother PCB.
Figure 7 presents another embodiment of this invention wherein the magnetic core goes through several PCB.
Figure 8 presents another embodiment of this invention wherein the magnetic core goes through several power PCB which contain high frequency switching electronic components and through the mother PCB.
Figure 9 presents another embodiment of this invention wherein a metal plate is attached to the power PCB.
Figure 10 presents another embodiment of this invention wherein a metal plate with cavities to accommodate some of the high frequency switching electronic components are attached to the power PCB.
Figure 11 presents another embodiment of this invention wherein some of the high heat dissipation components are located on an alumina substrate placed on a metal plate.
Figure 12 presents another embodiment of this invention wherein the high heat dissipation components are located on top of a thermally conductive insert further soldered to a copper foil edged on an isolated metal substrate board.
Figure 13 presents another embodiment of the invention wherein the power PCB, the high frequency switching electronic components for power processing cells, which can be multiplied to meet the power requirements.

### Drawings in Detail:

As described before, figure 1, illustrates the prior art of this invention.

In figure 2 is presented the preferred embodiment of the invention. There is a multilayer PCB , which incorporates the winding of the magnetic element 2316. There is a magnetic core 2310 of the magnetic element 2316. The winding 2318 of the magnetic element 2316 are constructed in the multilayer PCB 232.

The high frequency switching electronic components 238, which is connected to the magnetic element 2316 with minimum insertion impedance are also located on the multilayer PCB 232. The interconnection between the magnetic element 2316 and the high frequency switching electronic components 238 shall be made to minimize the parasitic inductance and with minimum impedance insertion.

The rest of the electronic components 236 of the electronic circuit are located on the mother PCD, 234 that can contain a reduced number of layers and as a result is lower cost.

In figure 3A is presented the magnetic element 2310, with the high frequency switching electronic components 238 and the interconnection pads 2350.

2350. In figure 3B is presented one of the embodiments of this patent referring to the method of attachment of attachment of the power PCB, 232, containing the magnetic element 16, and the mother PCB, 234. The power PCB 232 contains copper coated via 2524, which allow the penetration of the solder 2522B. The solder 2522B, creates a medium for current flow and also constitutes a mechanical bind between power PCB 232, and the mother PCB 234. There is a copper pad 2552B on the top of the mother PCB 231, and a copper pad 254B on the bottom of power PCB, 232. The melted solder 2522B, during the soldering process will spread in between 254B and 2552D and will further penetrate through 2524, creating a mechanical bound, and a path for current and heat flow.

In figure 3C is presented another embodiment of the invention wherein the interconnection between 232 and 231 is accomplished with the pin 2526C pressed in power PCB 232, and further soldered to 234.

In figure 3D the attachment between 232 and 234 is accomplished with the use of a pressed insert 2530D, The pressed insert has to be made from a conductive material, to create not only a bond but also a path for current and heat.

In figure 3E is presented another embodiment of the invention wherein the surface mounted pin 2510E is used as interconnection between 232 and 231. The surface mounted pin 2510E has to be electrically and thermally conductive to allow an efficient current and heat flow between 232 and 234.

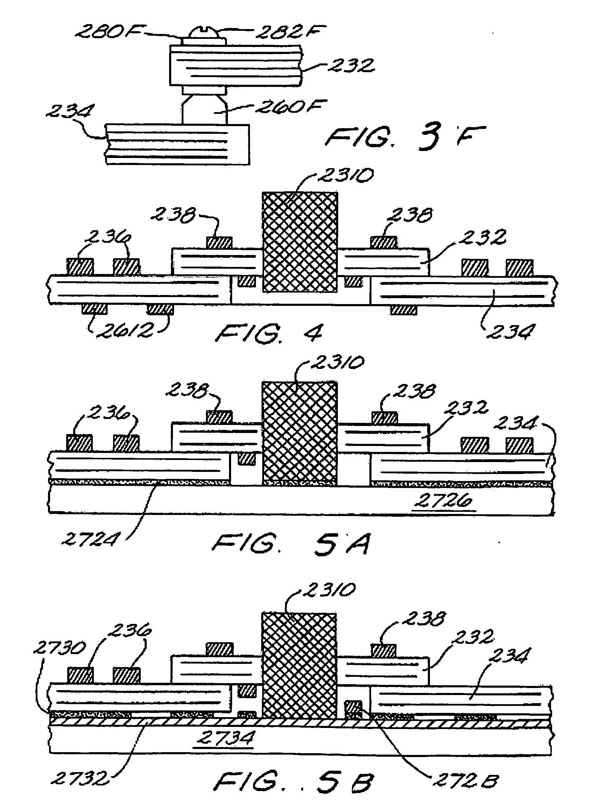

In figure 3F is presented another embodiment of the invention wherein the interconnection between 232 and 231 is provided by the pressed connectors 260F and 280F and a screw 282F. The pressed connector 260F is pressed fit in the mother PCB 231 and the pressed connector 280F is pressed fit in the power PCB 232. The screw 282F ensures a bond between 280F and 260F. The pressed inserts 260F and 280F should be also very good conductors for current and heat to create a very low electrical and thermal impedance path between 232 and 234.

In figure 4 is presented an embodiment of the invention wherein components 2612, are located on the bottom side of the mother PCB. In this way the power density of the power-processing device formed by the power PCB, Mother PCB, high frequency switching electronic components and the rest of the electronic components, can increase.

In figure 5A an additional metal plate 2726 is attached to the mother PCB 234, via a dielectric material 2724. In this way the heat can be extracted from the mother PCB to the metal plate 2726 which acts as a heatsink.

In figure 5B is presented another embodiment of the invention wherein an isolated metal substrate element composed by a metal plate 2734, a dielectric 2732 and copper foil 2730, is attached to the mother PCB. Additional electric components 2728 can be attached to the copper pads, edged on the copper foil 2730. This packaging method allows the heat transfer from the power PCB 232, and mother PCB 234, to be transferred to the metal plate 2731. The location of additional components as 272B, leads to an increased in power density.

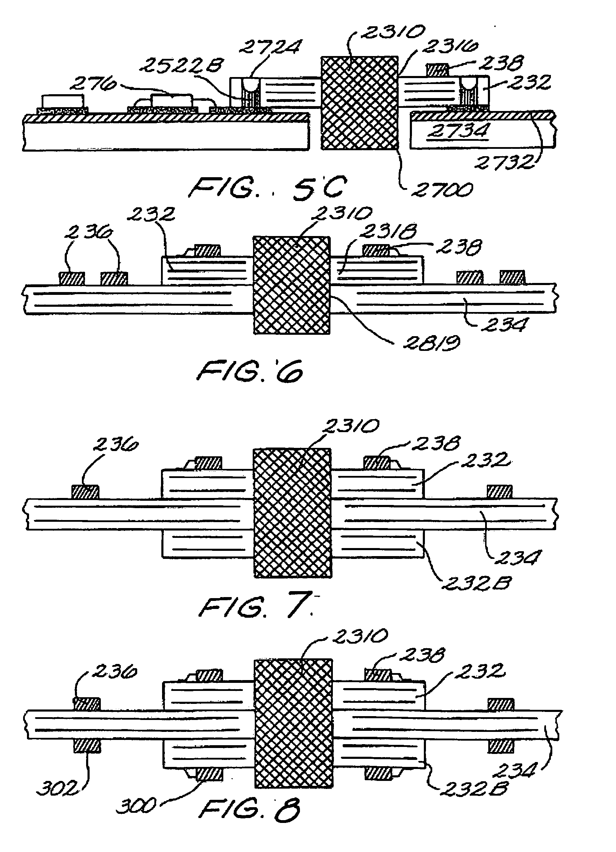

Figure 5C presents an embodiment of the invention in which the magnetic element 2316 is attached to an isolated metal substrate composed of a dielectric material 2732, copper foil 2752, and metal plate 2734. A cutout 2700 in the isolated metal substrate is performed to accommodate the magnetic core 2310. The interconnection between the isolated metal substrate and the magnetic element 2316 is made via the copper foil 2752 and via 2721. In the soldering process, the melted solder penetrates through via 2724, creating an electrical and mechanical bind.

The advantage of this embodiment is the fact that high power dissipating devices are located directly on the isolated metal substrate with very low thermal impedance to the metal plate 2734.

In figure 6, the magnetic core 2310 penetrates through, power PCB 232, and mother PCB, 234. In this way the winding 2318 created in the layers of the power PCB 232, and the windings 2819 created in the mother PCB 234, can be magnetically coupled. In this way it is increased the level of utilization of the mother PCB 234.

In figure 7 there are two power PCB linked magnetically through core 2310 with the mother PCB 234. This symmetrical structure can offer some advantages such as interleaving the primary and secondary winding of the magnetic structure using the magnetic core 2310.

In figure 8 there are high frequency switching electronic components located on both power PCB. As an application the primary winding of the transformer element using the magnetic core 2310, can be located on the mother PCB 234, the secondary winding can be implemented in the power PCB 232 and 232B and the additional high frequency switching electronic components such as rectifiers means can be surface mounted on 232 and 232B.

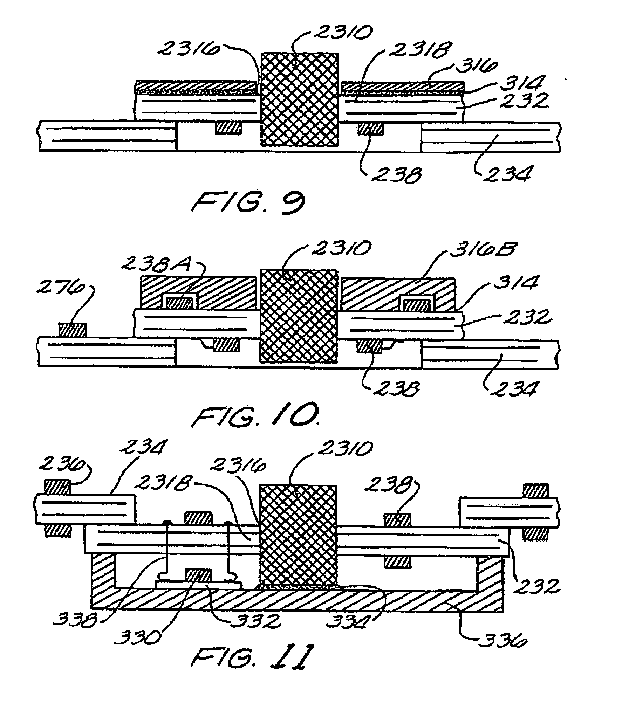

In figure 9 an additional metal plate 316 is attached to the power PCB 232, via a dielectric material 314. The heat produced by the magnetic element 2316, with winding 2318 and magnetic core 2310, and by the high frequency switching electronic components 238 can be transferred to 316 and further transferred to air or additional heatsink.

In figure 10 is presented similar concept as in figure 9, wherein some of the high frequency switching electronic components are located under the metal plate 316B. The metal plate 316B, has cavities to accommodate the components 238A placed on top of the power PCB 232

In figure 11 the high power dissipation electronic components 330, are located on an alumina substrate 332. The interconnection between the alumina substrate 332 and the power PCB 232 is provided by the pins 338. In between the magnetic core 2310 and the metal plate 336 there is a thermally conductive compressible pad 334. The module created by the power PCB with the high frequency switching electronic components 238, 330 the metal plate 336 is attached to the mother PCB 232. The advantage of this concept is the fact that it offers a good thermal path from the high heat dissipation components to a metal plate heatsink 336.

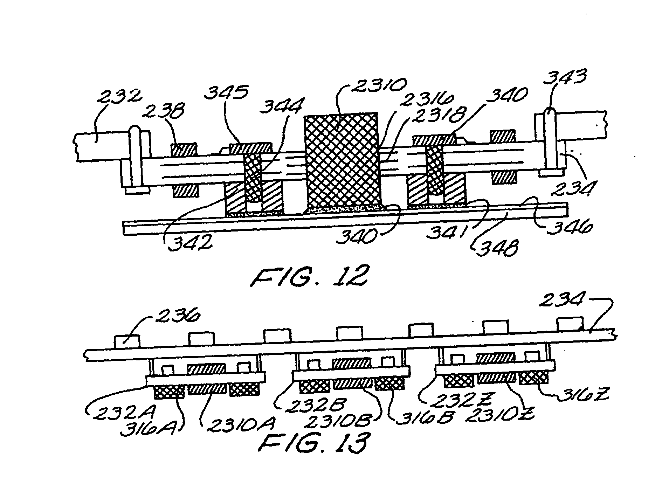

In figure 12 the high heat dissipation components as 340, are located on top of a heat conductive insert 344. The insert is further penetrating into a copper interface 342. Further the copper interface 312 is soldered to the copper foil 341 located on the dielectric 346, attached to a metal plate 348.
The mechanical structure formed by 344, 342, 341 can efficiently extract the heat from the device 340 to the metal plate 318. This mechanical structure can also efficiently be a path for the current flow. The power processing module formed by power PCB 234, high frequency switching electronic components such as 238 and 340, the thermal interface 344, 342, 341, dielectric layer 346 and the metal plate 348, can be further connected to the mother PCB 232

In figure 13 is presented a concept wherein multiple power PCBs 232A...232Z are employed. Each power PCB contains at least one magnetic element and the high frequency switching electronic components. The rest of the electronic components, such as the signal control portion are located on the mother PCB 234. Cooling plates 316A... 316Z can be further attached to the power PCB for cooling. In this embodiment, the high frequency switching electronic components and high heat dissipation components are located on the power PCB, separated from the rest of electronic components located on mother PCB, 234. In this concept the high power dissipation components, which in most of the power converters are also high frequency switching electronic components, are separated by the noise and heat sensitive components located on the mother PCB.

The size of high cost, large number of layers power PCB is reduced, leading to a low cost design. The high frequency switching high power dissipation electronic components are separated by the rest of the components leading to improve electrical-thermal characteristics. This packaging concept offers also increased flexibility. The number of power PCB, which includes magnetic elements and high frequency switching electronic components, can increase to increase the output power. These power-processing cells can be standardized to constitute the building blocks for any power systems.

It is clear from the foregoing that the present invention creates a highly improved transformer package which provides for the enhanced provision of power with the burden properly split between the transformers.

## Claims

1. An electronic assembly comprising:
a) an electronic board (234) having an opening therein, said electronic board (234) further including two pads positioned on a first surface of said electronic board (234) proximate to said opening;
b) a multilayer circuit board (232) having secured thereto a transformer (2316), said multilayer circuit board (232) positioned such that a portion of a first surface of said multilayer circuit board (232) engages the first surface of said electronic board such that a portion of a core (2310) of said transformer (2316) extends into the opening of said electronic board (234), said multilayer circuit board (232) having at least two channels there through, each of said channels aligned with one of said at least two pads of said electronic board (234); and
c) solder (2522B) extending through said at least two channels in said multilayer circuit board (232), said solder(2522B) bonded to the channel and to an associated pad on said electronic board (234); **characterized by**:
d) at least one electronic component (238) secured to the first surface of said multilayer circuit board (232) and enclosed within said opening in said electronic board (234).

2. The electronic assembly according to claim 1, further including high frequency switching electronic components (238) located on said multilayer circuit board (232), said high frequency switching electronic components feeding a primary and secondary high frequency loops of said transformer (2316).

3. The electronic assembly according to one of claims 1 or 2, further including at least one electronic component secured to an opposing second surface of said multilayer circuit board (232).

4. The electronic assembly according to one of claims 1 to 3, wherein, during operation of said electronic assembly, electrical current passes through said solder (2522B) extending through said at least two channels in said multilayer circuit board (232).

5. The electronic assembly according to claim 4,
a) wherein said multilayer circuit board (232) includes at least two aligning pins; and,
b) wherein said electronic board (234) includes at least two alignment holes adapted to receive said at least two aligning pins of said multilayer circuit board (232).

6. The electronic assembly according to claim 5, wherein said at least two aligning pins are not bonded with the at least two alignment holes of said electronic board (234).

## Patentansprüche

1. Elektronische Baugruppe, die Folgendes umfasst:
a) eine elektronische Platine (234) mit einer darin ausgebildeten Öffnung, wobei die elektronische Platine (234) des Weiteren zwei Kontaktinseln enthält, die auf einer ersten Fläche der elektronischen Platine (234) nahe der Öffnung angeordnet sind;
b) eine mehrschichtige Leiterplatte (232), an der ein Transformator (2316) befestigt ist, wobei die mehrschichtige Leiterplatte (232) so angeordnet ist, dass ein Abschnitt einer ersten Fläche der mehrschichtigen Leiterplatte (232) die erste Fläche der elektronischen Platine dergestalt in Eingriff nimmt, dass sich ein Abschnitt eines Kerns (2310) des Transformators (2316) in die Öffnung der elektronischen Platine (234) hinein erstreckt, wobei sich mindestens zwei Kanäle durch die mehrschichtige Leiterplatte (232) ziehen, wobei jeder der Kanäle auf eine der mindestens zwei Kontaktinseln der elektronischen Platine (234) ausgerichtet ist; und
c) Lot (2522B) , das sich durch die mindestens zwei Kanäle in der mehrschichtigen Leiterplatte (232) erstreckt, wobei das Lot (2522B) an den Kanal und an eine zugehörige Kontaktinsel auf der elektronischen Platine (234) gebondet ist; **gekennzeichnet durch**:
d) mindestens eine elektronische Komponente (238), die an der ersten Fläche der mehrschichtigen Leiterplatte (232) befestigt ist und die von der Öffnung in der elektronischen Platine (234) umschlossen wird.

2. Elektronische Baugruppe nach Anspruch 1, die des Weiteren elektronische Hochfrequenz-Schaltkomponenten (238) enthält, die sich auf der mehrschichtigen Leiterplatte (232) befinden, wobei die elektronischen Hochfrequenz-Schaltkomponenten eine primäre und eine sekundäre Hochfrequenzschleife des Transformators (2316) speisen.

3. Elektronische Baugruppe nach einem der Ansprüche 1 oder 2, die des Weiteren mindestens eine elektronische Komponente enthält, die an einer gegenüberliegenden zweiten Fläche der mehrschichtigen Leiterplatte (232) befestigt ist.

4. Elektronische Baugruppe nach einem der Ansprüche 1 bis 3, wobei, während des Betriebes der elektronischen Baugruppe, elektrischer Strom durch das Lot (2522B) fließt, das sich durch die mindestens zwei Kanäle in der mehrschichtigen Leiterplatte (232) erstreckt.

5. Elektronische Baugruppe nach Anspruch 4,
a) wobei die mehrschichtige Leiterplatte (232) mindestens zwei Ausrichtstifte enthält; und
b) wobei die elektronische Platine (234) mindestens zwei Ausrichtlöcher enthält, die dafür ausgelegt sind, die mindestens zwei Ausrichtstifte der mehrschichtigen Leiterplatte (232) aufzunehmen.

6. Elektronische Baugruppe nach Anspruch 5, wobei die mindestens zwei Ausrichtstifte nicht mit den mindestens zwei Ausrichtlöchern der elektronischen Platine (234) verbondet sind.

## Revendications

1. Ensemble électronique comprenant :
a) une carte électronique (234) dans laquelle est ménagée une ouverture, ladite carte électronique (234) comprenant en outre deux plages de connexion positionnées sur une première surface de ladite carte électronique (234) à proximité de ladite ouverture ;
b) une carte de circuit multicouche (232) à laquelle est fixé un transformateur (2316), ladite carte de circuit multicouche (232) étant positionnée de telle manière qu'une partie d'une première surface de ladite carte de circuit multicouche (232) s'engage sur la première surface de ladite carte électronique afin qu'une partie d'un noyau (2310) dudit transformateur (2316) pénètre dans l'ouverture ménagée dans ladite carte électronique (234), ladite carte de circuit multicouche (232) ayant au moins deux canaux la traversant, chacun desdits canaux étant aligné avec l'une desdites au moins deux plages de connexion de ladite carte électronique (234) ; et
c) de la soudure (2522B) s'étendant à travers lesdits au moins deux canaux dans ladite carte de circuit multicouche (232), ladite soudure (2522B) étant liée audit canal et à une plage de connexion associée sur ladite carte électronique (234) ; **caractérisé par** :
d) au moins un composant électronique (238) fixé à la première surface de ladite carte de circuit multicouche (232) et enfermé à l'intérieur de ladite ouverture ménagée dans ladite carte électronique (234).

2. Ensemble électronique selon la revendication 1, comprenant en outre des composants électroniques de commutation à haute fréquence (238) situés sur ladite carte de circuit multicouche (232), lesdits composants électroniques de commutation à haute fréquence alimentant des spires à haute fréquence primaires et secondaires dudit transformateur (2316).

3. Ensemble électronique selon l'une des revendications 1 ou 2, comprenant en outre au moins un composant électronique fixé à une seconde surface opposée de ladite carte de circuit multicouche (232).

4. Ensemble électronique selon l'une des revendications 1 à 3, dans lequel, pendant le fonctionnement dudit ensemble électronique, un courant électrique passe à travers ladite soudure (2522B) s'étendant à travers lesdits au moins deux canaux dans ladite carte de circuit multicouche (232).

5. Ensemble électronique selon la revendication 4,
a) dans lequel ladite carte de circuit multicouche (232) comprend au moins deux broches d'alignement ; et
b) dans lequel ladite carte électronique (234) comprend au moins deux trous d'alignement aptes à recevoir lesdites au moins deux broches d'alignement de ladite carte de circuit multicouche (232).

6. Ensemble électronique selon la revendication 5, dans lequel lesdites au moins deux broches d'alignement ne sont pas liées aux au moins deux trous d'alignement de ladite carte électronique (234).
